(19) Europäisches Patentamt / European Patent Office / Office européen des brevets

(11) **EP 1 655 388 B2**

(12) **NEW EUROPEAN PATENT SPECIFICATION**
After opposition procedure

(45) Date of publication and mention
of the opposition decision:
**16.03.2011 Bulletin 2011/11**

(45) Mention of the grant of the patent:
**15.10.2008 Bulletin 2008/42**

(21) Application number: **05445083.8**

(22) Date of filing: **26.10.2005**

(51) Int Cl.:
*C23C 16/40* (2006.01)   *C23C 30/00* (2006.01)
*C23C 28/04* (2006.01)   *C23C 16/02* (2006.01)
*B23B 27/14* (2006.01)

(54) **Alumina layer with controlled texture**

Aluminiumoxidschicht mit kontrollierter Textur

Couche d'alumine ayant une texture contrôlée

(84) Designated Contracting States:
**AT BE BG CH CY CZ DE DK EE ES FI FR GB GR HU IE IS IT LI LT LU LV MC NL PL PT RO SE SI SK TR**

(30) Priority: **05.11.2004 SE 0402693**

(43) Date of publication of application:
**10.05.2006 Bulletin 2006/19**

(73) Proprietor: **Seco Tools AB**
**732 82 Fagersta (SE)**

(72) Inventor: **Ruppi, Sakari**
**737 44 Fagersta (SE)**

(74) Representative: **Taquist, Henrik Lennart Emanuel**
**Sandvik Intellectual Property AB**
**811 81 Sandviken (SE)**

(56) References cited:
WO-A-95/19457   WO-A-98/10119
JP-A- 5 295 517   JP-A- 10 076 405
JP-A- 2002 028 803   US-A1- 2001 006 724
US-B1- 6 293 739

• JAE-GON KIM ET AL: "Effect of partial pressure of the reactant gas on the chemical vapour deposition of Al2O3" THIN SOLID FILMS, vol. 97, no. 1, 5 November 1982 (1982-11-05), pages 97-106, XP002365782 SWITZERLAND ISSN: 0040-6090

EP 1 655 388 B2

**Description**

The present invention relates to a method of producing a coated cutting tool insert designed to be used in metal machining. The substrate is cemented carbide, cermet, ceramics or cBN on which a hard and wear resistant coating is deposited. The coating exhibits an excellent adhesion to the substrate covering all functional parts thereof. The coating is composed of one or more refractory layers of which at least one layer is a strongly textured alpha-alumina ($\alpha$-$Al_2O_3$) deposited in the temperature range of 750-950 °C.

Background of the invention

A crucial step in the deposition of different $Al_2O_3$ polymorphs is the nucleation step. $\kappa$-$Al_2O_3$ can be grown in a controlled way on {111} surfaces of TiN, Ti(C,N) or TiC having the fcc structure. TEM has confirmed the growth mode which is that of the close-packed (001) planes of $\kappa$-$Al_2O_3$ on the close-packed {111} planes of the cubic phase with the following epitaxial orientation relationships: $(001)_{\kappa}$ // $(111)_{TiX}$; $[100]_{\kappa}$ // $[112]_{TiX}$. An explanation and a model for the CVD growth of metastable $\kappa$-$Al_2O_3$ have proposed earlier (Y. Yoursdshahyan, C. Ruberto, M. Halvarsson, V. Langer, S. Ruppi, U. Rolander and B.I. Lundqvist, Theoretical Structure Determination of a Complex Material: $\kappa$-Al2O3, J. Am. Ceram. Soc. 82(6)(1999)1365-1380).

When properly nucleated, $\kappa$-$Al_2O_3$ layers can be grown to a considerable thickness (>10$\mu$m). The growth of even thicker layers of $\kappa$-$Al_2O_3$ can be ensured through re-nucleation on thin layers of, for example TiN, inserted in the growing $\kappa$-$Al_2O_3$ layer. When nucleation is ensured the $\kappa$$\rightarrow$$\alpha$ transformation can be avoided during deposition by using a relatively low deposition temperature (<1000 °C). During metal cutting, the $\kappa$$\rightarrow$$\alpha$ phase transformation has confirmed to occur resulting in flaking of the coating. In addition, there are several other reasons why $\alpha$-$Al_2O_3$ should be preferred in many metal cutting applications. As shown earlier $\alpha$-$Al_2O_3$ exhibits better wear properties in cast iron, US 5,137,774.

However, the stable $\alpha$-$Al_2O_3$ phase has been found to be more difficult to be nucleated and grown at reasonable CVD temperatures than the metastable $\kappa$-$Al_2O_3$. It has been experimentally confirmed that $\alpha$-$Al_2O_3$ can be nucleated, for example, on $Ti_2O_3$ surfaces, bonding layers of (Ti,Al)(C,O) or by controlling the oxidation potential using $CO/CO_2$ mixtures as shown in US 5,654,035. The bottom line in all these approaches is that nucleation must not take place on the 111-surfaces of TiC, TiN, Ti(C,N) or Ti(C,O,N), otherwise $\kappa$-$Al_2O_3$ is obtained.

It should also be noted that in the prior-art methods higher deposition temperatures of about 1000 °C are usually used to deposit $\alpha$-$Al_2O_3$. When the nucleation control is not complete, as is the case in many prior-art products, the produced $\alpha$-$Al_2O_3$ layers have, at least partly, been formed as a result of the $\kappa$-$Al_2O_3$$\rightarrow$$\alpha$-$Al_2O_3$ phase transformation. This is especially the case when thick $Al_2O_3$ layers are considered. These kinds of $\alpha$-$Al_2O_3$ layers are composed of larger grains with transformation cracks. They exhibit much lower mechanical strength and ductility than the $\alpha$-$Al_2O_3$ layers that are composed of nucleated $\alpha$-$Al_2O_3$. Consequently, there is a need to develop techniques to control the nucleation step of $\alpha$-$Al_2O_3$.

The control of the $\alpha$-$Al_2O_3$ polymorph in industrial scale was achieved in the beginning of the 1990's with commercial products based on US patent 5,137,774. Later modifications of this patent have been used to deposit $\alpha$-$Al_2O_3$ with preferred layer textures. In US 5,654,035 an alumina layer textured in the (012) direction and in US 5,980,988 in the (110) direction are disclosed. In US 5,863,640 a preferred growth either along (012), or (104) or (110) is disclosed. US 6,333,103 describes a modified method to control the nucleation and growth of $\alpha$-$Al_2O_3$ along the (10(10)) direction. US 2002/0155325 describes a method to obtain a strong (300) texture in $\alpha$-$Al_2O_3$ using a texture modifying agent, $ZrCl_4$. The prior-art processes discussed above use all high deposition temperatures of about 1000 °C.

US 2004/0028951 describes a technique to achieve a pronounced (012) texture. The commercial success of this kind of product demonstrates the importance to refine the CVD process of $\alpha$-$Al_2O_3$ towards fully controlled textures.

JAE-GON KIM et al "Effect of partial pressure of the reactant gas on the chemical vapour deposition of Al2O3", THIN SOLID FILMS SWITZERLAND, vol 97, no. 1, 5 November 1982 (1982-11-05), pages 97-106 discloses films of $Al_2O_3$ deposited onto TiN-coated cemented carbide substrates by a chemical vapor deposition technique using $AlCl_3$, $CO_2$ and $H_2$ gases. The effects of the deposition temperature and the partial pressures of the reactants on the final structure of the $Al_2O_3$ film were investigated, especially the effect of the supersaturations of the reactants on the final structure of the $Al_2O_3$ film.

US 2001/006724 discloses coating a cutting tool with an aluminum oxide layer using a bonding layer that is preferably formed by aluminum titanate and has a flake-like crystal structure. This bonding layer improves the adherence of an aluminum oxide layer, in particular to underlying titanium nitride, titanium carbide, or titanium carbonitride layers.

It is well established that the water gas shift reaction, in the absence of $H_2S$ or other dopants, is the critical rate-limiting step for $Al_2O_3$ formation, and to a great extent, controls the minimum temperature at which $Al_2O_3$ can be deposited. Further it is well established that the water-gas shift reaction is very sensitive for deposition pressure.

Extensive work has been done to deposit CVD $Al_2O_3$ at lower temperatures. Several $Al_2O_3$ layers using other than $AlCl_3$-$CO_2$-$H_2$ system have been investigated, including $AlCl_3$-CO-$CO_2$, $AlCl_3$-$C_2H_5OH$, $AlCl_3$-$N_2O$-$H_2$,

$AlCl_3-NH_3-CO_2$, $AlCl_3-O_2-H_2O$, $AlCl_3-O_2-Ar$, $AlX_3-CO_2$ (where X is Cl, Br, I), $AlX_3-CO_2-H_2$ (where X is Cl, Br, I). $AlBr_3-NO-H_2-N_2$ and $AlBr_3-NO-H_2-N_2$- It is emphasised that these studies have been carried out without dopants (such as $H_2S$) and the effect of the deposition pressure has not been elucidated.

It is worth noting that none of these systems have been commercially successful. Consequently, to provide a CVD process for depositing $Al_2O_3$ layers at temperatures below those currently used on a commercial scale is therefore highly desirable.

US 6,572,991 describes a method to deposit $\gamma$-$Al_2O_3$ at low deposition temperatures. This work clearly shows that it is possible to obtain $Al_2O_3$ layers in the medium temperature range from the $AlCl_3-CO_2-H_2$ system. However, it was not realised that nucleation surface controls the phase composition of $Al_2O_3$ and that deposition of $\alpha$-$Al_2O_3$ is thus possible at lower deposition temperatures. In the prior-art, it was considered impossible to deposit $\alpha$-$Al_2O_3$ at low temperatures and it was believed that $\gamma$-$Al_2O_3$ and $\kappa$-$Al_2O_3$ were the unavoidable low temperature phases.

WO 95/19457 discloses a method of producing a cutting tool insert with a fine-grained $\alpha$-$Al_2O_3$ layer that has a strong (104) texture by means of a CVD process. The $\alpha$-$Al_2O_3$ layer is obtained by control of the oxidation potential of the CVD reactor atmosphere prior to the nucleation of the $Al_2O_3$. The nucleation of the $Al_2O_3$ is initiated by a controlled sequencing of reactant gases, wherein $CO_2$ and CO are first entering the reactor in a $H_2$ free atmosphere in the presence of $N_2$ or Ar, and then $H_2$ and $AlCl_3$ are allowed into the reactor. The $Al_2O_3$ layer is deposited at a temperature of 1000°C, with a pressure of up to 100 mbar and in the presence of up to 0,2% $H_2S$. In order to improve the toughness of the coating surface, the inserts were wet blasted.

Objects and summary of the invention

It is an object of the present invention is to provide a new, improved alumina layer where the $\alpha$-$Al_2O_3$ phase consists of nucleated $\alpha$-$Al_2O_3$ with a strong, fully controlled (104) growth texture. According to the present invention $\alpha$-$Al_2O_3$ with the controlled (104) texture can be obtained within a wide temperature range from 750 to 950 °C, which can be considered surprising. This object is achieved by a method as defined in claim 1. Preferred embodiments are defined in claims 2 to 8.

The alumina layer with strong texture outperforms the prior art with random or other less developed and incompletely controlled textures, Further, increased toughness can be obtained when deposition is carried out at lower temperatures. Compared with prior-art products the $\alpha$-$Al_2O_3$ layer obtained according the present invention is essentially free from transformation stresses, consisting of columnar, defect free, $\alpha$-$Al_2O_3$ grains with low dislocation density and with improved cutting properties. The texture-controlled $\alpha$-$Al_2O_3$ layers deposited at medium temperature (about 800°C) show enhanced toughness.

Description of the drawings and figures

Fig. 1 shows a cross-section SEM image at a magnification of 5000x of a typical alumina layer according to the present invention deposited on a MTCVD-Ti(C,N) layer. The alumina layer is composed of columnar grains. It is dense with no detectable porosity.

Fig. 2 shows a cross-section SEM image of a typical layer according the prior-art (magnification 6000x) deposited on a MTCVD-Ti(C,N) layer. The alumina layer is composed of large nearly equiaxed grains. Porosity is visible in the alumina layer. Interfacial porosity between the alumina layer and the Ti(C,N) layer is also visible.

Detailed description of the invention

A method to deposit $\alpha$-$Al_2O_3$ with a strong (104) texture in a temperature range of 750 to 950°C is described. The invention utilises short pulses of precursors followed by purging steps with an inert gas such as Ar. After the purge another precursor is applied as a short pulse. In addition to the texture control the method can be used to produce finer grain sizes by increasing the number of nucleation sites.

$Al_2O_3$ layers obtained according to the present invention outperform the prior-art and are especially suitable be used in toughness demanding stainless steel application such as interrupted cutting, turning with coolant and especially intermittent turning with coolant. The other area is cast iron where the edge strength of this kind of alumina layer is superior to the prior art.

Ti(C,N) layer is used as an intermediate layer, which can be obtained either by conventional CVD or MTCVD, preferably by MTCVD. The present invention makes it possible to deposit $\alpha$-$Al_2O_3$ at the same temperature as is used to deposit the intermediate MTCVD Ti(C,N) layer. Consequently, the heating-up period can be omitted after MTCVD.

To nucleate $\alpha$-$Al_2O_3$ with the specified texture several steps are needed. First, on the Ti(C,N) layer a bonding layer characterised by the presence of an Al concentration gradient is deposited. Nitrogen and $CH_3CN$ are applied during deposition of this bonding layer. The aluminium content on the surface of this layer is considerably, about 30%, higher than in the bonding layer according to US 5,137,774 (prior-art) and the bonding layer is obviously containing nitrogen. The surface of this bonding layer is subjected to an additional treatment(s).

Nucleation is started with an $AlCl_3/TiCl_4/H_2$ pulse with a duration of 5 minutes. After that an Ar purge (duration 5 minutes) is applied in order to remove excess $Cl^-$ from the surface. After this an oxidising pulse is applied using a $CO_2/H_2/N_2/Ar$ ($N_2$ = 25%, Ar=balance) gas mixture. In addition to a relatively low oxidation potential of the gas mixture the oxidising step has to be relatively short, about 0.5-5 minutes to secure (104) nucleation. These steps should be repeated several times, preferably 2-5 times in sequence to increase the amount of $\alpha\text{-}Al_2O_3$ nuclei. It is noted that if pulsating nucleation is used, one has to find an optimised combination between the duration of the individual steps and the amount of the steps, otherwise too low or excessive oxidisation may be obtained. A person skilled in the art can find the correct procedure by trial and error.

The key to obtain the specified growth texture is the control of the oxidation potential of the $CO_2/H_2/N_2/Ar$ mixture by adjustment of the $N_2:CO_2$ ratio. This ratio should be 450-650, preferably 450-550. The use of controlled oxygen potential in combination with the correct time and number of pulses enables the correct nucleation mode. Typical pulse times may range from 10 seconds to 5 minutes depending on the duration of the pulse. The oxidising pulse is again followed by an Ar purge. These steps should be repeated several times, preferably 2-5 times, in sequence to increase the amount of $\alpha\text{-}Al_2O_3$ nuclei. Excessive oxidisation must be avoided. A person skilled in the art can find the best and optimised combination between the duration and the amount of the steps.

Detailed description of the nucleation steps

1. Depositing a bonding layer 0.1-1 $\mu$m thick in a gas mixture of 2-3 % $TiCl_4$, $AlCl_3$ increasing from 0.5 to 5 %, 3-7 % CO, 1-3 % $CO_2$, 2-10 % $N_2$ and balance $H_2$ at about 750-1000 °C, preferably at 800°C and at a pressure of 50-200 mbar.
2. Purging by Ar for 5 min.
3. Treating the bonding layer in a gas mixture of 1-2 % $TiCl_4$ and 2-4% $AlCl_3$ in hydrogen for 2-60 min at 750-1000°C, preferably at 800 °C, and at a pressure of 50-200 mbar.
4. Purging by Ar for 5 min.
5. Treating in a gas mixture of 0.05 to 0.1 % $CO_2$, preferably 0.05%, 20 to 65% $N_2$, preferably 22.5-27.5% at $CO_2$ = 0.05%, 10% $H_2$, balance Ar at a pressure of 50-200 mbar for 0.5-5 minutes at a temperature of 750-1000°C depending on the temperature for the subsequent deposition of the alumina layer.
6. Purging by Ar for 5 min.
7. Repeating steps 3-6 to obtain the optimum oxidisation level.
8. Depositing an alumina layer at a temperature of 750-950 °C using higher deposition pressures (200-500 mbar) together with higher amounts (0.5-1.5%) of catalysing precursors such as $H_2S$ or $SO_x$, preferably $H_2S$.
The growth of the alumina layer onto the nucleation layer is started by sequencing the reactant gases in the following order: CO, $AlCl_3$, $CO_2$. The process temperatures of 750 to 950°C can be used since the texture is determined by the nucleation surface.

The present invention also relates to a method of producing cutting tool insert consisting of a substrate at least partially coated with a coating with a total thickness of 15-40 $\mu$m, preferably 20-25 $\mu$m consisting of one or more refractory layers of which at least one layer is an alpha alumina layer. The $\alpha\text{-}Al_2O_3$ layer deposited according to the present invention is dense and exhibits a very low defect density. It is composed of columnar grains with a strong (104) texture. The columnar grains have a length/width ratio of from 2 to 12, preferably 4 to 8.

The texture coefficients (TC) for the $\alpha\text{-}Al_2O_3$ layer obtained according to the present invention is determined as follows:

$$TC(hkl) = \frac{I(hkl)}{I_0(hkl)} \left\{ \frac{1}{n} \sum \frac{I(hkl)}{I_0(hkl)} \right\}^{-1}$$

where

I(hkl) = intensity of the (hkl) reflection
$I_0$(hkl) = standard intensity according to JCPDS card no 46-1212

n = number of reflections used in the calculation
(hkl) reflections used are: (012), (104), (110), (113), (024), (116).

The texture of the alumina layer is defined as follows:
TC(104) >2.0, preferably >3. Simultaneously TC(012), TC(110), TC(113), TC(024) should be all <1.0, preferably <0.5. Note that the related (012) and (024) reflections are also low. However, for this growth mode TC(116) is somewhat higher than the other background reflections. TC(116) should be less than 1.2, preferably less than 1.

The substrate comprises a hard material such as cemented carbide, cermets, ceramics, high speed steel or a superhard material such as cubic boron nitride (CBN) or diamond preferably cemented carbide or CBN. With CBN is herein meant a cutting tool material containing at least 40 vol-% CBN. In a preferred embodiment the substrate is a cemented carbide with a binder phase enriched surface zone.

The coating comprises a first layer adjacent the body of CVD Ti(C,N), CVD TiN, CVD TiC, MTCVD Ti(C,N), MTCVD Zr(C,N), MTCVD Ti(B,C,N), CVD HfN or combinations thereof preferably of Ti(C,N) having a thickness of from 1 to 20 $\mu$m, preferably from 1 to 10 $\mu$m and said $\alpha$-$Al_2O_3$ layer adjacent said first layer having a thickness of from about 1 to 40 $\mu$m, preferably from 1 to 20 $\mu$m, most preferably from 1 to 10 $\mu$m. Preferably there is an intermediate layer of TiN between the substrate and said first layer with a thickness of <3 $\mu$m, preferably 0.5-2 $\mu$m.

In one embodiment the $\alpha$-$Al_2O_3$ layer is the uppermost layer

In another embodiment there is a layer of carbide, nitride, carbonitride or carboxynitride of one or more of Ti, Zr and Hf, having a thickness of from about 0.5 to 3 $\mu$m, preferably 0.5 to 1.5 $\mu$m atop the $\alpha$-$Al_2O_3$ layer. Alternatively this layer has a thickness of from about 1 to 20 $\mu$m, preferably 2 to 8 $\mu$m.

In yet another embodiment the coating includes a layer of $\kappa$-$Al_2O_3$ and/or $\gamma$-$Al_2O_3$ preferably atop the $\alpha$-$Al_2O_3$ with a thickness of from 0.5 to 10, preferably from 1 to 5 $\mu$m.

Example 1

Cemented carbide cutting inserts with a composition of 5.9% Co and balance WC (hardness about 1600 HV) were coated with a layer of MTCVD Ti(C,N). The thickness of the MTCVD layer was about 2 $\mu$m. On to this layer two different layers consisting of about 10 $\mu$m $\alpha$-$Al_2O_3$ were deposited:

**Layer a)** contained a (104) textured layer and was deposited layer a) is not obtained in accordance with the invention at 1000°C. The detailed process data is given in Table 1.
**Layer b)** was deposited according to the prior art.
**Layer c)** contained a (104) textured layer and was deposited according to the present invention at 800°C. The detailed process data is given in Table 2.

Table 1 Deposition process for a Layer a) with (104) texture at 1000°C:

| Step 1: Bonding layer | | |
|---|---|---|
| Gas mixture | $TiCl_4$ | = 2.8% |
| | $AlCl_3$ | = 0.8 -4.2% |
| | CO | = 5.8% |
| | $CO_2$ | = 2.2 % |
| | $N_2$ | = 5-6% |
| | Balance: | $H_2$ |
| Duration | 60 min | |
| Temperature | 1000 °C | |
| Pressure | 100 mbar | |
| Step 2: Purge | | |
| Gas | Ar | =100% |
| Duration | 5 min | |
| Temperature | 1000 C | |
| Pressure | 50 mbar | |

(continued)

### Step 3: Pulse 1

| Gas mixture | $TiCl_4$ | = 1.6% |
| | $AlCl_3$ | = 2.8 |
| | $H_2$ | = Balance |
| Duration | 2-5 min depending on the amount of pulses. | |
| Temperature | 1000 C | |
| Pressure | 50 mbar | |

### Step 4: Purge

| Gas | Ar | =100% |
| Duration | 5 min | |
| Temperature | 1000 C | |
| Pressure | 50 mbar | |

### Step 5: Pulse 2

| Gas mixture | $CO_2$ | = 0.05% |
| | $N_2$ | = 25% |
| | Balance: | $H_2$ |
| Duration | 0.5-1 min depending on the amount of pulses. | |
| Temperature | 1000 °C | |
| Pressure | 100 mbar | |

### Step 6: Purge

| Gas | Ar | =100% |
| Duration | 5 min | |
| Temperature | 1000 C | |
| Pressure | 50 mbar | |

### Step 7: Nucleation step

| Gas mixture | $AlCl_3$ | = 3,2 % |
| | HCl | = 2.0 % |
| | $CO_2$ | = 1.9 % |
| | Balance | $H_2$ |
| Duration | 60 min | |
| Temperature | 1000 °C | |
| Pressure | 210 mbar | |

### Step 8: Deposition

| Gas mixture | $AlCl_3$ | = 4.2 % |
| | HCl | = 1.0% |
| | $CO_2$ | = 2.1% |
| | $H_2S$ | = 0.2% |
| | Balance: | $H_2$ |
| Duration | 520 min | |
| Temperature | 1000 °C | |

(continued)

| Step 8: Deposition | |
|---|---|
| Pressure | 50 mbar |

It should be noted that the steps 3-7 can be repeated five to ten times in sequence in order to obtain grain refinement and the strong desired texture. The amount of pulses can be even higher if the duration of step 6 is reduced. In this example the steps 3-7 were repeated three times with durations of 0.6 minutes.

Table 2. Deposition process for a Layer c) with (104) texture at 780 °C:

| Step 1: Bonding layer | | |
|---|---|---|
| Gas mixture | $TiCl_4$ | = 2.8% |
| | $CH_3CN$ | = 0.7% |
| | $AlCl_3$ | = increasing from 0.8 to 4.2% |
| | CO | = 5.8% |
| | $CO_2$ | = 2.2 % |
| | $N_2$ | = 5% |
| | Balance: | $H_2$ |
| Duration | 40 min | |
| Temperature | 780 °C | |
| Pressure | 100 mbar | |

| Step 2: Purge | | |
|---|---|---|
| Gas | Ar | =100% |
| Duration | 5 min | |
| Temperature | 780°C | |
| Pressure | 50 mbar | |

| Step 3: Pulse 1 | | |
|---|---|---|
| Gas mixture | $TiCl_4$ | = 1.6% |
| | $AlCl_3$ | = 2.8 |
| | $H_2$ | = Balance |
| Duration | 5 min. | |
| Temperature | 780°C | |
| Pressure | 50 mbar | |

| Step 4: Purge | | |
|---|---|---|
| Gas | Ar | =100% |
| Duration | 5 min | |
| Temperature | 780°C | |
| Pressure | 50 mbar | |

| Step 5: Pulse 2 | | |
|---|---|---|
| Gas mixture | $CO_2$ | = 0.05% |
| | $N_2$ | =25% |
| | $H_2$ | = 10% |
| | Balance: | Ar |
| Duration | 2 min | |
| Temperature | 780°C | |

(continued)

| Step 5: Pulse 2 | | |
|---|---|---|
| Pressure | 100 mbar | |

| Step 6: Purge | | |
|---|---|---|
| Gas | Ar | =100% |
| Duration | 5 min | |
| Temperature | 780°C | |
| Pressure | 50 mbar | |

| Step 7: Nucleation step | | |
|---|---|---|
| Gas mixture | $AlCl_3$ | = 3,2 % |
| | HCl | = 2.0 % |
| | $CO_2$ | = 1.9 % |
| | Balance | $H_2$ |
| Duration | 60 min | |
| Temperature | 780°C | |
| Pressure | 50 mbar | |

| Step 8: Deposition | | |
|---|---|---|
| Gas mixture | $AlCl_3$ | = 4.1 % |
| | HCl | = 1.0 % |
| | $CO_2$ | = 2.3% |
| | $H_2S$ | = 0.9% |
| | Balance: | $H_2$ |
| Duration | 600 min | |
| Temperature | 780°C | |
| Pressure | 350 mbar | |

Steps 3-6 were repeated three times.

Example 2

Layers a, b and c were studied using X-ray diffraction. The texture coefficients were determined are presented in Table 3. As clear from Table 3 the layer according to the present invention exhibits a strong (104) texture when deposited. Typically, for this growth mode the (116) reflection is somewhat more profound than the other background reflections.

Table 3.

| Hkl | layer a | Prior art, layer b, | Invention, layer c |
|---|---|---|---|
| 012 | 0.24 | 0.97 | 0.49 |
| 104 | 4.30 | 1.14 | 3.13 |
| 110 | 0.06 | 0.95 | 0.49 |
| 113 | 0.19 | 0.99 | 0.41 |
| 024 | 0.27 | 0.86 | 0.49 |
| 116 | 0.94 | 1.09 | 0.99 |

Example 3

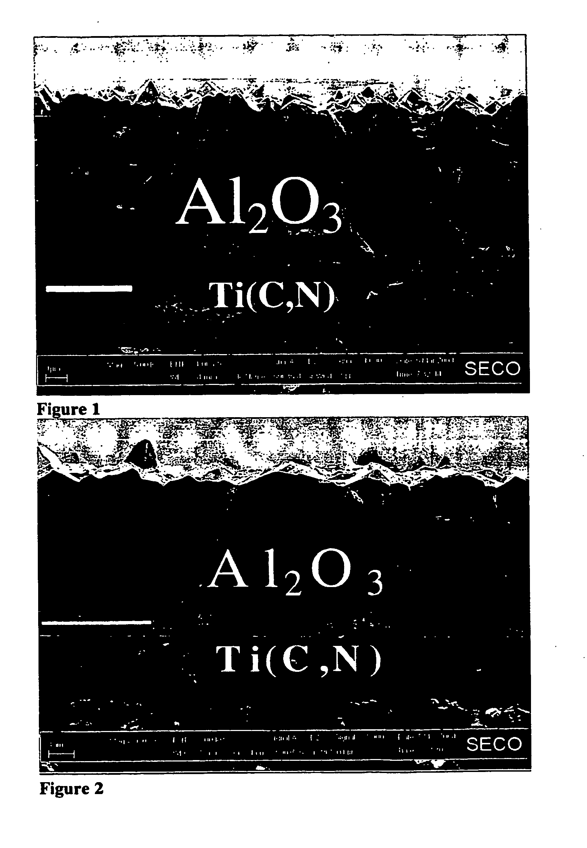

Layers a) and b) were studied using Scanning electron microscopy. The cross section images of the layers are shown in Figs. 1 and 2, respectively. The differences in microstructure and morphology are clear.

Example 4

The layers a) and b) from the Example 1 were tested with respect to edge chipping in longitudinal turning of cast iron.

| | |
|---|---|
| Work piece: | Cylindrical bar |
| Material: | SS0130 |
| Insert type: | SNUN |
| Cutting speed: | 400 m/min |
| Feed: | 0.4 mm/rev |
| Depth of cut: | 2.5 mm |
| Remarks: | dry turning |

The inserts were inspected after 2 and 4 minutes of cutting. As is clear from Table 4 the edge toughness of the prior art product was considerably enhanced when the layer was produced according to the present invention.

Table 4

| | Flaking of the edge line (%) after 2 minutes | Flaking of the edge line (%) After 6 minutes |
|---|---|---|
| Layer a | 0 | 6 |
| Layer b | 12 | 22 |

Example 5

The layer produced according to the present invention was compared with a market leader, referred here as Competitor X. This coating is composed of MTCVD Ti(C,N) and $\alpha$-Al$_2$O$_3$. XRD was used to determine the texture coefficients for these competitor coatings. Two inserts from Competitor X were randomly chosen for XRD. Table 5 shows the obtained TCs for the Competitor X. The coatings from Competitor X exhibit a random texture and can be compared with the present invention, Table 1.

Table 5

| Hkl | TC(hkl) | |
|---|---|---|
| 012 | 0.71 | 0.57 |
| 104 | 0.92 | 0.86 |
| 110 | 1.69 | 1.92 |
| 113 | 0.48 | 0.40 |
| 024 | 1.16 | 1.14 |
| 116 | 1.04 | 1.11 |

The X-rayed inserts from the competitor X were compared with inserts produced according to the present invention, Layer a).

Two inserts produced according to the present invention were compared with the two Competitor X inserts with respect to flank wear resistance in face turning of ball bearing material:

| | |
|---|---|
| Work piece: | Cylindrical tubes (Ball bearings) |
| Material: | SS2258 |
| Insert type: | WNMG080416 |
| Cutting speed: | 500 m/min |
| Feed: | 0.5 mm/rev |
| Depth of cut: | 1.0 mm |
| Remarks: | Dry turning |

(continued)

Tool life criteria:    Flank wear >0.3 mm, three edges of each variant were tested.

Results:        Tool life (min)
Layer a         25.0
Layer a         23.5
Competitor 1    14.5    (prior art)
Competitor 2    15.5    (prior art)

Example 6

Layer a), b) and c) deposited on Co-enriched substrates were tested with respect to toughness in longitudinal turning with interrupted cuts.

Work piece:        Cylindrical slotted bar
Material:          SS1672
Insert type:       CNMG120408-M3
Cutting speed:     140 m/min
Feed:              0.1, 0.125, 0.16, 0.20, 0.25, 0.315, 0.4, 0.5, 0.63, 0.8 mm/rev gradually increased after 10 mm length of cut
Depth of cut:      2.5 mm
Remarks:           dry turning
Tool life criteria:    Gradually increased feed until edge breakage. Ten edges of each variant were tested.

Table 6

|                     | Mean feed at breakage (mm/rev) |
|---------------------|--------------------------------|
| Layer a             | 0.24                           |
| Layer b (prior art) | 0.12                           |
| Layer c (invention) | 0.32                           |

The test results show (Table 6) that layer c according to the present invention exhibited clearly better toughness behaviour than the prior-art (layer b).

Example 7

Cubic boron nitride (CBN) insert containing about 90 % of polycrystalline CBN (PCBN) were coated according to the present invention and according to prior art layer discussed in Example1. The coated CBN was compared with uncoated CBN insert in cutting of steel containing ferrite. It is known that B has a high affinity to ferrite and diffusion wear occurs at high cutting speeds. As shown in Table 7 the layer according to the present invention is superior to the prior art.

Work piece:        Cylindrical bar
Material:          SS0130
Insert type:       SNUN
Cutting speed:     750 m/min
Feed:              0.4 mm/rev
Depth of cut:      2.5 mm
Remarks:           dry turning

Table 7

|  | Life time (min) |
|---|---|
| Coated CBN (Invention) | 26 |
| Coated according to prior art | 11 |
| Uncoated CBN | 9 |

**Claims**

1. A method of producing a cutting tool insert consisting of a substrate at least partially coated with a coating with a total thickness of 10-40 $\mu$m, preferably 15-25 $\mu$m consisting of one or more refractory layers of which at least one layer is an alumina layer, said alumina layer being composed of columnar $\alpha$-Al$_2$O$_3$ grains with texture coefficients

   a) TC(104) >3,
   b) TC(012), TC(110), TC(113), TC(024) all <1.0, preferably <0.5,
   c) TC(116) <1.2, preferably <1.0,

   the texture coefficient TC(hkl) being defined as

$$TC(hkl) = \frac{I(hkl)}{I_0(hkl)} \left\{ \frac{1}{n} \sum \frac{I(hkl)}{I_0(hkl)} \right\}^{-1}$$

   where
   I(hkl) = measured intensity of the (hkl) reflection
   I$_0$(hkl) = standard intensity according to JCPDS card no 46-1212
   n = number of reflections used in the calculation
   (hkl) reflections used are: (012), (104), (110), (113), (024), (116),
   said columnar grains with the length/width ratio from 2 to 12, preferably 4 to 8,
   **characterized in that** said alumina layer is deposited at a temperature of 750-950°C <u>and</u> obtained by modification of the nucleation surface by pulses of gas mixtures of (AlCl$_3$/TiCl$_4$/H$_2$) and (CO$_2$/N$_2$/H$_2$/Ar) with intermitting Ar purging steps with an N$_2$:CO$_2$ ratio of 450-650, said nucleation surface being a bonding layer of (Ti,Al)(C,O,N) with increasing Al content towards the nucleation surface, and depositing the $\alpha$-Al$_2$O$_3$ layer in the temperature range of 750-950°C at a pressure of 20-50 kPa and in the presence of 0,5-1,5 % of H$_2$S or SO$_x$ as a catalyzing agent.

2. A method according to claim 1, **characterized in that** said substrate comprises cemented carbide, CBN or sintered CBN alloy.

3. A method according to any of the previous claims, **characterized in that** the coating comprises a first layer adjacent the body of CVD Ti(C,N), CVD TiN, CVD TiC, MTCVD Ti(C,N), MTCVD Zr(C,N), MTCVD Ti(B,C.N), CVD HfN or combinations thereof preferably of Ti(C,N) having a thickness of from 1 to 20 $\mu$m, preferably from 1 to 10 $\mu$m and said $\alpha$-Al$_2$O$_3$ layer adjacent said first layer having a thickness of from about 1 to 40 $\mu$m, preferably from 1 to 20 $\mu$m, most preferably from 1 to 10 $\mu$m.

4. A method according to any of the previous claims, **characterized in that** the $\alpha$-Al$_2$O$_3$ layer is the uppermost layer.

5. A method according to any of claims 1-3, **characterized in** a layer of carbide, nitride, carbonitride or carboxynitride of one or more of Ti, Zr and Hf, having a thickness of from about 0.5 to 12 $\mu$m, preferably 0.5 to 6 $\mu$m, atop the $\alpha$-Al$_2$O$_3$ layer.

6. A method according to any of claims 1-3, **characterized in** a layer of $\kappa$-Al$_2$O$_3$ or $\gamma$-Al$_2$O$_3$ atop the $\alpha$-Al$_2$O$_3$ with a thickness of from 0.5 to 10, preferably from 1 to 5 $\mu$m.

7.  A method according to any of the previous claims, **characterized in** a layer of TiN between the substrate and said first layer with a thickness of <3 $\mu$m, preferably 0.5-2 $\mu$m.

8.  A method according to any of the previous claims, **characterized in that** said substrate comprises cemented carbide with a binder phase enriched surface zone.

**Patentansprüche**

1.  Verfahren zum Herstellen eines Schneidwerkzeugeinsatzes bestehend aus einem Substrat, welches wenigstens zum Teil mit einer Beschichtung beschichtet ist, die eine Gesamtdicke von 10 - 40 $\mu$m, vorzugsweise 15 - 25 $\mu$m, aufweist und die aus einer oder mehreren hitzebeständigen Schichten besteht, von denen wenigstens eine Schicht eine Aluminiumoxidschicht ist, wobei dass diese Aluminiumoxidschicht aus säulenförmigen $\alpha$-$Al_2O_3$-Kömern mit den Texturkoeffizienten

    a) TC(104) >3,
    b) TC(012), TC(110), TC(113), TC(024) alle <1,0, vorzugsweise <0,5,
    c) TC(116) <1,2, vorzugsweise <1,0,

    zusammengesetzt ist, wobei der Texturkoeffizient TC(hkl) als

$$TC(hkl) = \frac{I(hkl)}{I_o(hkl)} \left\{ \frac{1}{n} \sum \frac{I(hkl)}{I_o(hkl)} \right\}^{-1}$$

    definiert ist, wobei
    I(hkl) = gemessene Intensität der (hkl)-Reflexion,
    $I_o$(hkl) = Standardintensität gemäß JCPDS-Karte Nr. 46-1212,
    n = Anzahl der Reflexionen, die bei der Berechnung verwendet werden,
    wobei die (hkl)-Reflexionen, die verwendet werden: (012), (104), (110), (113), (024), (116) sind, und
    wobei die säulenförmigen Körner ein Länge-/Breite-Verhältnis von 2 bis 12, vorzugsweise 4 bis 8, aufweisen,
    **dadurch gekennzeichnet, dass**
    die Aluminiumoxidschicht bei einer Temperatur von 750 - 950°C abgeschieden wird und erhalten wird durch Modifikation der Kristallisationsoberfläche durch Pulse von Gasgemischen von ($AlCl_3$/$TiCl_4$/$H_2$) und ($CO_2$/$H_2$/$N_2$/Ar) mit intermittierenden Ar-Spülstufen mit einem $N_2$:$CO_2$-Verhältnis von 450-650, wobei die Kristallisationsoberfläche eine Bindeschicht von (Ti,Al)(C,O,N) mit einem ansteigenden Aluminiumgehalt in Richtung der Kristallisationsoberfläche ist, und wenn man die $\alpha$-$Al_2O_3$-Schicht in dem Temperaturbereich von 750-950°C bei einem Druck von 20-50 kPa und in der Gegenwart von 0,5-1,5% $H_2$S oder $SO_x$ als ein Katalysierungsmittel abscheidet.

2.  Verfahren nach Anspruch 1, **dadurch gekennzeichnet, dass** das Substrat Hartmetall, CBN oder gesinterte CBN-Legierung umfaßt.

3.  Verfahren nach einem der vorangehenden Ansprüche, **dadurch gekennzeichnet, dass** die Beschichtung eine erste an den Körper angrenzende Schicht von CVD Ti(C,N), CVD TiN, CVD TiC, MTCVD Ti(C,N), MTCVD Zr(C, N), MTCVD Ti(B,C,N), CVD HfN oder Kombinationen davon umfaßt, vorzugsweise von Ti(C,N) mit einer Dicke von 1 bis 20 $\mu$m, vorzugsweise von 1 bis 10 $\mu$m, und wobei die an diese erste Schicht angrenzende $\alpha$-$Al_2O_3$-Schicht eine Dicke von etwa 1 bis 40 $\mu$m, vorzugsweise von 1 bis 20 $\mu$m, besonders bevorzugt von 1 bis 10 $\mu$m, aufweist

4.  Verfahren nach einem der vorangehenden Ansprüche, **dadurch gekennzeichnet, dass** die $\alpha$-$Al_2O_3$-Schicht die oberste Schicht ist.

5.  Verfahren nach einem der Ansprüche 1 bis 3, **dadurch gekennzeichnet, dass** eine Schicht von Carbid, Nitrid, Carbonitrid oder Carboxynitrid von einem oder mehreren von Ti, Zr und Hf mit einer Dicke von etwa 0,5 bis 12 $\mu$m, vorzugsweise 0,5 bis 6 $\mu$m, auf der $\alpha$-$Al_2O_3$-Schicht vorliegt.

6. Verfahren nach einem der Ansprüche 1 bis 3, **gekennzeichnet durch** eine Schicht von $\kappa$-Al$_2$O$_3$ oder $\gamma$-Al$_2$O$_3$ auf dem $\alpha$-Al$_2$O$_3$ mit einer Dicke von 0,5 bis 10, vorzugsweise von 1 bis 5 $\mu$m.

7. Verfahren nach einem der vorangehenden Ansprüche, **gekennzeichnet durch** eine Schicht von TiN zwischen dem Substrat und der ersten Schicht mit einer Dicke von <3 $\mu$m, vor zugsweise 0,5-2 $\mu$m.

8. Verfahren nach einem der vorangehenden Ansprüche, **dadurch gekennzeichnet, dass** das Substrat ein Hartmetall mit einem mit einer Binderphase angereicherten Oberflächenbereich umfaßt.

**Revendications**

1. Procédé de fabrication d'un insert pour outil de coupe, consistant en un substrat, revêtu au moins partiellement d'un revêtement ayant une épaisseur totale de 10 à 40 $\mu$m, de préférence de 15 à 25 $\mu$m, consistant en une ou plusieurs couches réfractaires, dont au moins une couche est une couche d'alumine, ladite couche d'alumine étant composée de grains colonnaires d'$\alpha$-Al$_2$O$_3$, ayant des coefficients de texture :

   a) TC(104)>3.
   b) TC(012), TC(110), TC(113), TC(024) tous <1,0, de préférence < 0,5.
   c) TC (116) < 1,2, de préférence < 1,0,

   le coefficient de texture TC(hkl) étant défini comme:

$$TC(hkl) \;=\; \frac{I(hkl)}{I_0(hkl)} \left\{ \frac{1}{n} \sum \frac{I(hkl)}{I_0(hkl)} \right\}^{-1}$$

   dans laquelle
   I(hkl) = intensité mesurée de la réflexion (hkl)
   I$_0$(hkl) = intensité standard selon document JCPDS n° 46-1212
   n = nombre de réflexions utilisées dans le calcul
   les réflexions (hkl) utilisées sont : (012), (104), (110), (113), (024), (116) et
   lesdits grains colonnaires ayant un rapport longueur/largeur de 2 à 12, de préférence de 4 à 8,
   **caractérisé en ce que** ladite couche d'alumine est déposée à une température de 750 à 950°C, et obtenue par modification de la surface de nucléation, par des impulsions de mélanges gazeux de (AlCl$_3$/TiCl$_4$/H$_2$) et (CO$_2$/H$_2$/N$_2$/Ar), avec des étapes intermittentes de purge à l'Ar, avec un rapport N$_2$:CO$_2$ de 450 à 650, ladite surface de nucléation étant une couche de liaison de (Ti,Al)(C,O,N), avec une teneur en aluminium allant en augmentant lorsqu'on s'approche de la surface de nucléation et en déposant la couche en $\alpha$-Al$_2$O$_3$, dans la plage de température de 750 à 950°C, à une pression de 20 à 50 kPa et en présence de 0,5 à 1,5 % de H$_2$S ou de SO$_x$ en tant qu'agent catalyseur.

2. Procédé selon la revendication 1, **caractérisé en ce que** ledit substrat comprend du carbure cémenté, du CBN ou un alliage CBN fritté.

3. Procédé selon l'une quelconque des revendications précédentes, **caractérisé en ce que** le revêtement comprend une première couche, adjacente au corps de CVD Ti(C,N), CVD TiN, CVD TiC, MTCVD Ti(C,N), MTCVD Zr(C,N), MTCVD Ti(B,C,N), CVD HfN, ou des combinaisons de ceux-ci, de préférence de Ti(C,N), ayant une épaisseur de 1 à 20 $\mu$m, de préférence de 1 à 10 $\mu$m, et ladite couche en $\alpha$-Al$_2$O$_3$, adjacente à ladite première couche, ayant une épaisseur de 1 à 40 $\mu$m, de préférence de 1 à 20 $\mu$m, de manière la mieux préférée de 1 à 10 $\mu$m.

4. Procédé selon l'une quelconque des revendications précédentes, **caractérisé en ce que** la couche en $\alpha$-Al$_2$O$_3$ est la couche en position la plus haute.

5. Procédé selon l'une quelconque des revendications 1 à 3, **caractérisé en ce qu'**une couche de carbure, nitrure, carbonitrure ou carboxynitrure, d'un ou plusieurs matériaux parmi Ti, Zr et Hf, ayant une épaisseur de 0,5 à 12 $\mu$m, de préférence de 0,5 à 6 $\mu$m, est située au-dessus de la couche en $\alpha$-Al$_2$O$_3$.

**6.** Procédé selon l'une quelconque des revendications 1 à 3, **caractérisé en ce qu'**une couche en $\kappa$-$Al_2O_3$, ou une couche en $\gamma$-$Al_2O_3$, au dessus de la couche de $\alpha$-$Al_2O_3$, ayant une épaisseur de 0,5 à 10 $\mu$m, de préférence de 1 à 5 $\mu$m, est prévue.

**7.** Procédé selon l'une quelconque des revendications précédentes, **caractérisé en ce qu'**une couche de TiN, d'une épaisseur <3 $\mu$m, de préférence de 0,5 à 2 $\mu$m, est prévue entre le substrat et ladite première couche.

**8.** Procédé selon l'une quelconque des revendications précédentes, **caractérisé en ce que** ledit substrat comprend une couche en carbure cémenté, avec une zone de surface enrichie par une phase de liant.

**Figure 1**

**Figure 2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5137774 A
- US 5654035 A
- US 5980988 A
- US 5863640 A
- US 6333103 B
- US 20020155325 A
- US 20040028951 A
- US 2001006724 A
- US 6572991 B
- WO 9519457 A

**Non-patent literature cited in the description**

- **Y. Yoursdshahyan ; C. Ruberto ; M. Halvarsson ; V. Langer ; S. Ruppi ; U. Rolander ; B.I. Lundqvist.** Theoretical Structure Determination of a Complex Material: κ-Al2O3. *J. Am. Ceram. Soc.,* 1999, vol. 82 (6), 1365-1380
- **JAE-GON KIM et al.** Effect of partial pressure of the reactant gas on the chemical vapour deposition of Al2O. *THIN SOLID FILMS,* 05 November 1982, vol. 97, 97-106